# EUROPEAN PATENT APPLICATION

(11) **EP 4 822 372 A1**
(43) Date of publication of application: **14.10.2026**
(21) Application number: 25892293.9
(22) Date of filing: 22.09.2025
(51) Int. Cl.: G01R 31/392, G01R 31/3842, G01R 31/396, G01R 31/367, H01M 10/48, B60L 58/16

(54) **APPARATUS AND METHOD FOR DIAGNOSING BATTERY**

(30) Priority: 15.11.2024 KR 20240163391; 03.04.2025 KR 20250043679
(71) Applicant: LG Energy Solution, Ltd., Seoul 07335 (KR)
(72) Inventor: KIM, Hae-Rin, Daejeon 34122 (KR); KIM, Yong-Jun, Daejeon 34122 (KR); HWANG, Gyu-Yeong, Daejeon 34122 (KR)
(74) Representative: Plasseraud IP
(86) International application number: PCT/KR2025/014717
(87) International publication number: WO 2026/106081

(57) **Abstract**

An apparatus for diagnosing a battery according to an embodiment of the present disclosure comprises a data obtaining unit configured to obtain battery data including at least one of voltage, current, and temperature of the battery; and a processor configured to estimate a positive electrode active material loss rate of the battery based on the battery data by referring to a first profile provided for estimating a positive electrode active material loss related to cation mixing and a second profile provided for estimating a positive electrode active material loss related to particle cracking.

## Description

### TECHNICAL FIELDx

The present disclosure relates to an apparatus and method for diagnosing a battery, and more particularly, to an apparatus and method for diagnosing a battery, which estimates a positive electrode active material loss rate of a battery.

This application is based on and claims priority from Korean Patent Application No. 10-2024-0163391, filed on November 15, 2024, and Korean Patent Application No. 10-2025-0043679, filed on April 3, 2025, with the Korean Intellectual Property Office, the disclosure of which is incorporated herein in its entirety by reference.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Existing battery state estimation technologies primarily utilize the Pseudo Two Dimensional (P2D) model. The P2D model mathematically simulates the electrochemical reactions and material transport occurring within a lithium-ion battery to predict performance, and it may explain battery behavior by combining particle- and domain-level phenomena. Specifically, the P2D model simulates lithium-ion diffusion and electrochemical reactions by reflecting the porous structure of the electrode and ion transport within the electrolyte, and it may analyze structural deformation and performance degradation occurring during charge and discharge through concentration gradients and mechanical stress changes within the electrode particles. Through this, the P2D model may model battery degradation mechanisms, such as positive electrode active material loss.

The P2D model is a physics-based, detailed electrochemical model that offers the advantage of precise predictions according to battery state changes. Therefore, the P2D model is suitable for detailed analysis of battery degradation mechanisms, based on high prediction accuracy.

However, the high prediction accuracy of the P2D model requires a high amount of computation and memory resources. In other words, because applying the P2D model requires a complex calculation process and large-scale data storage, there is a limitation that it is difficult to apply the P2D model in a real-time processing system environment. In particular, when applying the P2D model directly to an onboard BMS (Battery Management System) in a vehicle or a cloud BMS operating on a network, a large amount of computational resources are required, which is inefficient in environments where the battery state must be quickly diagnosed and controlled.

Therefore, there is a need to develop a lightweight model (RM: Reduced Model) that reduces the complexity of the P2D model and enables real-time processing.

### DISCLOSURE

### Technical Problem

The present disclosure is designed to solve the problems of the related art, and therefore the present disclosure is directed to providing an apparatus and method for diagnosing a battery, which may accurately estimate an active material loss rate of a positive electrode by utilizing battery data based on a lightweight model and improve the efficiency of battery diagnosis by ensuring real-time performance.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a data obtaining unit configured to obtain battery data including at least one of voltage, current, and temperature of the battery; and a processor configured to estimate a positive electrode active material loss rate of the battery based on the battery data by referring to a first profile provided for estimating a positive electrode active material loss related to cation mixing and a second profile provided for estimating a positive electrode active material loss related to particle cracking.

The first profile may be configured to represent a corresponding relationship between a plurality of reference battery data and a plurality of first reference state data.

The second profile may be configured to represent a corresponding relationship between a plurality of reference battery data and a plurality of second reference state data.

The processor may be configured to determine first reference state data corresponding to the voltage and the temperature of the battery data by referring to the first profile.

The processor may be configured to estimate a first loss rate based on the determined first reference state data.

The processor may be configured to estimate the first loss rate based on the first reference state data and a damping factor.

The processor may be configured to determine second reference state data corresponding to the voltage and the current of the battery data by referring to the second profile.

The processor may be configured to estimate a second loss rate based on the determined second reference state data.

The processor may be configured to estimate the second loss rate based on the second reference state data and a damping factor.

The processor may be configured to estimate first reference state data corresponding to the voltage and the temperature of the battery data as a first loss rate by referring to the first profile.

The processor may be configured to estimate second reference state data corresponding to the voltage and the current of the battery data as a second loss rate by referring to the second profile.

The processor may be configured to estimate the positive electrode active material loss rate based on the first loss rate and the second loss rate.

The processor may be configured to calculate a value obtained by adding the first loss rate and the second loss rate as the positive electrode active material loss rate.

The processor may be configured to calculate a positive electrode active material loss amount of the battery during a reference period based on the positive electrode active material loss rate and the reference period between a previous diagnosis time point and a current diagnosis time point.

The processor may be configured to calculate a cumulative positive electrode active material loss amount up to the current diagnosis time point by adding the positive electrode active material loss amount to a cumulative positive electrode active material loss amount up to the previous diagnosis time point.

A battery pack according to another aspect of the present disclosure may comprise the apparatus for diagnosing a battery.

A vehicle according to still another aspect of the present disclosure may comprise the apparatus for diagnosing a battery.

A server according to still another aspect of the present disclosure may comprise the apparatus for diagnosing a battery.

A method for diagnosing a battery according to still another aspect of the present disclosure may comprise obtaining battery data including at least one of voltage, current, and temperature of the battery; and estimating a positive electrode active material loss rate of the battery based on the battery data by referring to a first profile provided for estimating a positive electrode active material loss related to cation mixing and a second profile provided for estimating a positive electrode active material loss related to volume change due to particle cracking.

A computer-readable storage medium according to still another aspect of the present disclosure may be a computer-readable storage medium storing a program for executing the method for diagnosing a battery on a computer.

### Advantageous Effects

According to one aspect of the present disclosure, the positive electrode active material loss rate under various operating conditions may be quickly and efficiently estimated by referring to the pre-stored first profile and second profile.

In addition, according to one aspect of the present disclosure, the state of the battery may be precisely diagnosed by independently analyzing the positive electrode active material loss rate due to cation mixing and particle cracking using the first and second profiles according to conditions such as voltage, current, and temperature.

In addition, according to one aspect of the present disclosure, the progress of battery deterioration may be comprehensively diagnosed by estimating the positive electrode active material loss rate, which reflects the total proportion of positive electrode active material consumed by a complex interaction of various factors such as cation mixing and particle cracking.

In addition, according to one aspect of the present disclosure, the positive electrode active material loss rate may be quickly estimated using a profile (e.g., a lookup table, etc.) composed of pre-calculated data using the P2D model, and an accuracy close to the precise calculation result of the P2D model may be maintained.

In addition, according to one aspect of the present disclosure, by estimating the first loss rate and second loss rate using a damping factor, the actual degradation pattern of the battery may be more accurately simulated, and the reliability of battery state diagnosis may be improved.

In addition, according to one aspect of the present disclosure, the state of the battery may be precisely diagnosed and the safety of the battery may be improved by comparing the loss amount with a threshold value.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating an apparatus for diagnosing a battery according to an embodiment of the present disclosure.
FIG. 2 is a diagram schematically illustrating an embodiment of the first profile.
FIG. 3 is a diagram schematically illustrating an embodiment of the second profile.
FIG. 4 is a diagram illustrating the correlation between the P2D model and the positive electrode active material loss rate estimated using the apparatus for diagnosing a battery according to an embodiment of the present disclosure.
FIG. 5 to FIG. 7 are diagrams schematically illustrating the SOH, the first positive electrode active material loss amount, and the second positive electrode active material loss amount, respectively, according to charge and discharge cycles.
FIG. 8 is a schematic diagram illustrating a battery pack according to another embodiment of the present disclosure.
FIG. 9 is a drawing schematically illustrating a vehicle according to still another embodiment of the present disclosure.
FIG. 10 is a drawing schematically illustrating a server according to still another embodiment of the present disclosure.
FIG. 11 is a diagram schematically showing a method for diagnosing a battery according to still another embodiment of the present disclosure.
FIG. 12 is a drawing schematically illustrating the sub-steps of step S1120 of FIG. 11.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

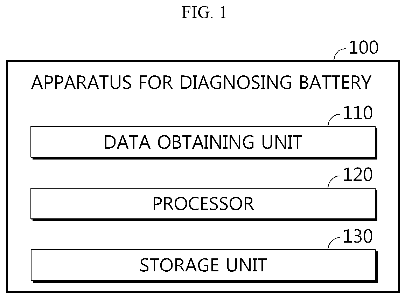

FIG. 1 is a diagram schematically illustrating an apparatus 100 for diagnosing a battery according to an embodiment of the present disclosure.

Referring to FIG. 1, the apparatus 100 for diagnosing a battery may include a data obtaining unit 110 and a processor 120. The apparatus 100 for diagnosing a battery may further include a storage unit 130.

The data obtaining unit 110 may be configured to obtain battery data including at least one of voltage, current, and temperature of the battery.

Here, the battery refers to an independent cell that has a negative electrode terminal and a positive electrode terminal and is physically separable. As an example, a lithium-ion cell or a lithium polymer cell may be considered a battery. Additionally, the type of battery may be cylindrical type, prismatic type, or pouch type. In addition, the battery may mean a battery bank, a battery module, or a battery pack in which a plurality of cells are connected in series and/or parallel. Hereinafter, for convenience of explanation, the battery is explained as meaning one independent cell.

In one embodiment, the data obtaining unit 110 may directly measure the voltage, current, and temperature of the battery. Specifically, the data obtaining unit 110 may measure the positive electrode voltage and the negative electrode voltage through a pair of voltage sensing lines connected to the positive electrode and the negative electrode of the battery, respectively. In addition, the data obtaining unit 110 may measure the voltage across both terminals of the battery based on the voltage difference between the measured positive electrode voltage and the negative electrode voltage. The data obtaining unit 110 may be connected to the battery through a current measurement unit to measure the current of the battery. For example, the current measurement unit may be a current sensor or a shunt resistor installed in the charging/discharging path of the battery to measure the current of the battery. Here, the charging/discharging path of the battery may be a high current path through which a charging current is applied to the battery or a discharging current is output from the battery. The data obtaining unit 110 may measure the temperature of the battery using a temperature sensor. That is, the data obtaining unit 110 may obtain battery data by directly measuring the voltage, current, and temperature of the battery. In addition, the data obtaining unit 110 may obtain battery data by measuring the voltage, current, and temperature of the battery at regular intervals or irregularly.

In another embodiment, the data obtaining unit 110 may receive battery data from the outside. That is, the data obtaining unit 110 may receive battery data from the outside by being communicatively connected to the outside by wire and/or wirelessly. For example, the data obtaining unit 110 may receive battery data from the outside through CAN (Controller Area Network) communication or CAN-FD (CAN with Flexible Data rate) communication. As another example, the data obtaining unit 110 may receive battery data from the outside through Zigbee, Bluetooth, Wi-Fi, or mobile communication network. Of course, as long as it supports communication between the data obtaining unit 110 and the outside, the type of the communication protocol is not particularly limited.

In another embodiment, the data obtaining unit 110 may receive battery data from a user (e.g., a driver, a mechanic, etc.). The data obtaining unit 110 is communicatively connected to an input means (e.g., a keyboard, a touch panel, a microphone, etc.) that receives battery data from the user, and may receive battery data through the input means.

The data obtaining unit 110 may be connected to the processor 120 via a wire and/or wireless connection to enable communication with the processor 120. The data obtaining unit 110 may transmit the acquired battery data to the processor 120. The processor 120 may receive the battery data from the data obtaining unit 110.

The processor 120 may be configured to estimate a positive electrode active material loss rate of the battery based on battery data by referring to a first profile provided for estimating a positive electrode active material loss related to cation mixing and a second profile provided for estimating a positive electrode active material loss related to particle cracking.

Here, the positive electrode active material loss rate represents the amount of active material lost per hour from the positive electrode of the battery, and may be used as an important indicator for evaluating the deterioration rate of the battery. Specifically, the positive electrode active material loss rate quantitatively indicates the rate at which the active material of the positive electrode is lost during battery charging, discharging, or storage.

The positive electrode active material loss refers to the phenomenon of active material decreasing in the positive electrode of a lithium-ion battery, and acts as one of the main causes of battery deterioration. Specifically, the positive electrode active material loss phenomenon may refer to the phenomenon of active material decreasing in the positive electrode due to structural damage or decomposition of the positive electrode material during charge/discharge cycles, oxidation of the positive electrode material during long-term storage of the battery, or formation of a surface inactive layer. If the positive electrode active material loss amount accumulates, the capacity and output of the battery may decrease.

The first profile is a data set (e.g., lookup table, mathematical function) used to estimate the positive electrode active material loss rate related to the cation mixing phenomenon, and represents the corresponding relationship between at least one of the battery voltage, current, and temperature and the positive electrode active material loss rate due to cation mixing.

Specifically, the first profile reflects the effect of cation mixing phenomenon on positive electrode active material loss and may be used to estimate the positive electrode active material loss rate under various battery conditions.

The second profile is a data set (e.g., lookup table, mathematical function) used to estimate the positive electrode active material loss rate related to the particle cracking phenomenon, and represents the corresponding relationship between at least one of the battery voltage, current, and temperature and the positive electrode active material loss rate due to particle cracking.

Specifically, the second profile reflects the effect of the phenomenon of stress accumulation and crack formation inside the particle due to repeated volume changes occurring during the charge and discharge process on the positive electrode active material loss, and may be used to estimate the positive electrode active material loss rate under various battery conditions.

The apparatus 100 for diagnosing a battery has the advantage of being able to quickly and efficiently estimate the positive electrode active material loss rate under various operating conditions of the battery by referring to the pre-stored first profile and second profile.

Meanwhile, the data obtaining unit 110 and/or the processor 120 included in the apparatus 100 for diagnosing a battery may optionally include application-specific integrated circuits (ASICs), other chipsets, logic circuits, registers, communication modems, data processing devices, etc. known in the art to execute various diagnosis logics performed in the present disclosure. Also, when the control logic is implemented as software, the data obtaining unit 110 and/or the processor 120 may be implemented as a set of program modules. At this time, the program module may be stored in the memory and executed by the data obtaining unit 110 and/or the processor 120. The memory may be inside or outside the data obtaining unit 110 and/or the processor 120 and may be connected to the data obtaining unit 110 and/or the processor 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the data obtaining unit 110 and/or the processor 120 are defined.

Specifically, the storage unit 130 may store information necessary for the processor 120 to estimate the positive electrode active material loss rate of the battery. For example, the storage unit 130 may store battery data, a first profile, a second profile, etc. In addition, the processor 120 may access the storage unit 130 to obtain information necessary for the processor 120 to estimate the positive electrode active material loss rate of the battery. For example, the battery data obtained by the data obtaining unit 110 is stored in the storage unit 130, and the processor 120 may access the storage unit 130 to obtain the stored battery data.

Below, the first profile and second profile are described in detail.

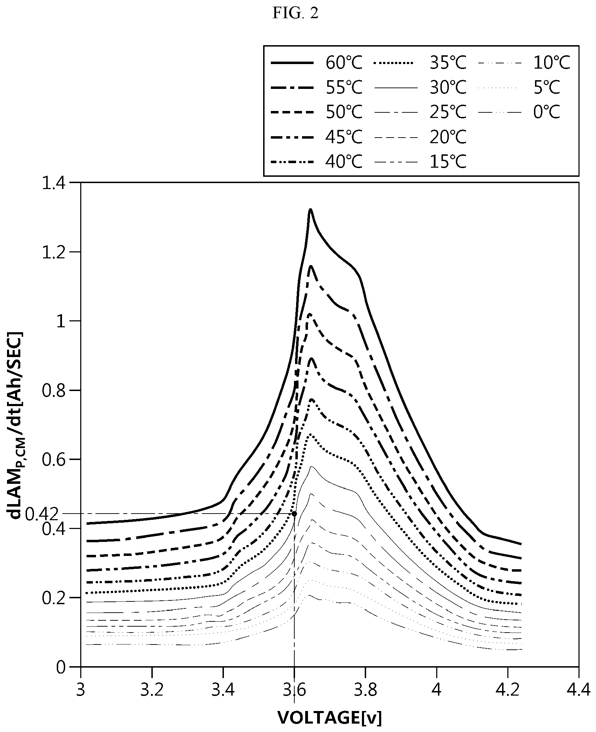

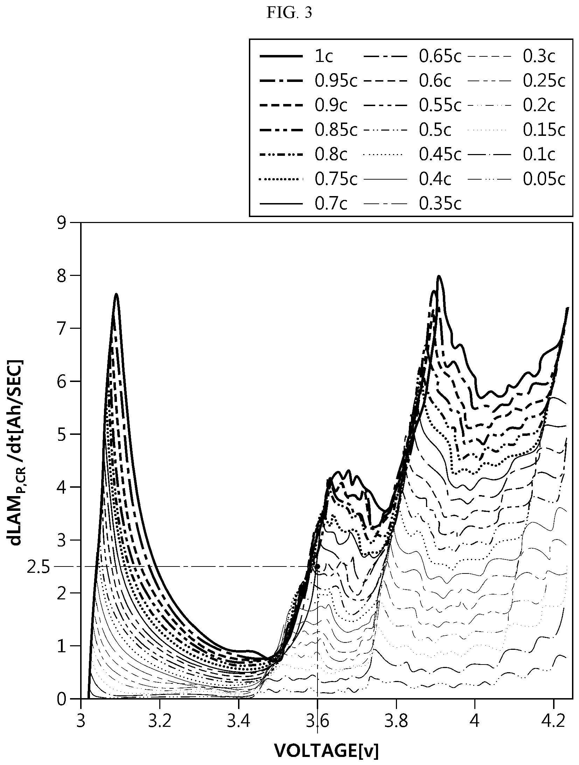

FIG. 2 is a diagram schematically illustrating an example of the first profile, and FIG. 3 is a diagram schematically illustrating an example of the second profile.

The first profile may be configured to represent a corresponding relationship between a plurality of reference battery data and a plurality of first reference state data. Specifically, the first profile may be configured based on a preset first model.

The second profile may be configured to represent a corresponding relationship between a plurality of reference battery data and a plurality of second reference state data. Specifically, the second profile may be configured based on a preset second model.

Here, the reference battery data is basic data input to the first model and the second model, and includes the voltage range, current range, and temperature range while the battery is being charged and discharged. For example, the reference battery data is the voltage, current, and temperature data of a reference battery of the same type as the battery to be diagnosed. Preferably, the reference battery data may be set to the voltage, current, and temperature data when the reference battery is in a BOL state.

The first reference state data is an output value obtained by inputting at least one of the voltage, current, and temperature of a reference battery of the same type as the diagnosis target battery into the first model. Preferably, the first reference state data may be set to a positive electrode active material loss rate according to cation mixing obtained by inputting battery data when the reference battery is in a BOL state into the first model.

The second reference state data is an output value obtained by inputting at least one of the voltage, current, and temperature of a reference battery of the same type as the diagnosis target battery into the second model. Preferably, the second reference state data may be set to a positive electrode active material loss rate due to particle cracking obtained by inputting battery data when the reference battery is in a BOL state into the second model.

The first model and the second model may be models that may estimate the positive electrode active material loss rate using the P2D model.

The first model may be defined as a model that estimates the positive electrode active material loss rate related to the cation mixing phenomenon. The first model may estimate the positive electrode active material loss rate by reflecting the cation mixing phenomenon that occurs under specific voltage, current, and temperature conditions of the battery.

The first model may be a pseudo-cation mixing model that simulates the cation mixing phenomenon at the positive electrode. Specifically, the cation mixing phenomenon refers to the phenomenon in which lithium ions and transition metal ions (e.g., nickel, cobalt) exchange places at the positive electrode of a lithium-ion battery, and acts as one of the main causes of battery performance degradation and deterioration.

The first model assumes hypothetical cation mixing to explain positive electrode degradation, which occurs primarily in the intermediate SOC region (SOC 50 to 60%).

Specifically, at low SOC states, nickel ions (Ni²⁺) are more likely to migrate to lithium ion (Li⁺) sites within the NCM crystal structure, but since lithium-ion sites are relatively scarce in this region, the actual occurrence of cation mixing may be limited.

On the other hand, at high SOC states, nickel ions (Ni²⁺) are oxidized and converted to nickel ions (Ni⁴⁺), which reduces the tendency of nickel ions to migrate to lithium-ion sites. Therefore, in the high SOC region, even if there are many vacancies for lithium ions, the possibility of antisite defects occurring is relatively low.

Based on the above characteristics, the first model may be composed as cation mixing governing equations such as Equations 1 and 2 below. [Equation 1] $\frac{{dLAM}_{P , CM}}{dt} = {i}_{CM} \left(t\right) ⋅ A ⋅ {L}_{p} ⋅ {a}_{p}$

Here, $\frac{{dLAM}_{P , CM}}{dt}$ is the positive electrode active material loss rate due to cation mixing. i_{CM}(t) is the current density related to cation mixing at a specific time t, A is the electrode plate area, Lₚ is the thickness of the positive electrode, and aₚ is the specific interfacial surface area of the positive electrode. [Equation 2] ${i}_{CM} \left(t\right) = {f}_{CM} \left({Ni}_{Li}\left(t\right),T\left(t\right)\right)$

Here, i_{CM}(t) is the current density related to cation mixing at a specific time t, and f_{CM} is a function that determines the current density related to cation mixing, indicating that the current density related to cation mixing depends on the lithium-ion concentration and temperature. Ni_{Li}(t) is the lithium-ion concentration in the electrode at a specific time t, and T(t) is the temperature of the battery at a specific time t.

The second model may be defined as a model that estimates the positive electrode active material loss rate related to the particle cracking phenomenon. The second model may estimate the positive electrode active material loss rate by reflecting the particle cracking phenomenon that occurs under specific voltage, current, and temperature conditions of the battery.

The second model may be a pseudo particle cracking model that simulates the particle cracking phenomenon caused by the volume change of the positive electrode. Specifically, the particle cracking phenomenon caused by the volume change may refer to a phenomenon in which stress accumulates inside the particle due to the repeated expansion and contraction of the particle caused by the intercalation and de-intercalation of lithium ions during the charge and discharge process, and cracks occur in the particle when this stress exceeds a threshold value. Such cracking causes the physical loss of the active material in the positive electrode, which acts as one of the main causes of battery performance degradation and deterioration.

The second model assumes that when current is applied to the battery, the volume of the positive electrode decreases due to de-lithiation during charging, which causes cracks to occur between the primary particles, allowing electrolyte to penetrate into the extra space between them, leading to deterioration of the positive electrode.

Based on the above features, the second model may be composed as particle cracking governing equations such as Equations 3 and 4 below. [Equation 3] $\frac{{dLAM}_{P , CR}}{dt} = {i}_{CR} \left(t\right) ⋅ A ⋅ {L}_{p} ⋅ {a}_{p}$

Here, $\frac{{dLAM}_{P , CR}}{dt}$ is the positive electrode active material loss rate due to particle cracking. i_{CR}(t) is the current density related to particle cracking at a specific time t, A is the electrode plate area, Lₚ is the thickness of the positive electrode, and aₚ is specific interfacial surface area of the positive electrode. [Equation 4] ${i}_{CR} \left(t\right) = {f}_{CR} \left(ΔV\left(t\right),T\left(t\right)\right)$

Here, i_{CR}(t) is the current density related to particle cracking, and f_{CR} is a function that determines the current density related to particle cracking, indicating that the current density related to particle cracking depends on the lithium-ion concentration and temperature. △V(t) is the volume change of the positive electrode at a specific time t, and T(t) is the temperature of the battery at a specific time t.

The processor 120 may determine first reference state data corresponding to the battery data by referring to the first profile, and estimate the first loss rate based on the determined first reference state data.

The first loss rate may refer to the positive electrode active material loss rate related to the cation mixing phenomenon at the positive electrode of the battery.

The processor 120 may be configured to determine first reference state data corresponding to the voltage and temperature of the battery data by referring to the first profile, and estimate the first loss rate based on the determined first reference state data.

Voltage is closely related to the state of charge (SOC) of the battery, and depending on the SOC and voltage conditions, there may be specific voltage ranges where cation mixing may occur. In these voltage ranges, positive electrode active material loss due to cation mixing is likely to accelerate. Furthermore, because voltage indicates the progress of electrochemical reactions within a battery, degradation mechanisms such as cation mixing may become more active at certain voltages. Therefore, voltage information may be useful in estimating the positive electrode active material loss state of the battery.

Temperature affects the rate of chemical reactions within a battery, and elevated temperatures may accelerate deterioration. Lithium-ion batteries are particularly sensitive to temperature, and high temperatures may exacerbate positive electrode active material loss. Therefore, temperature information may be used as a key indicator for assessing battery deterioration.

Current represents the rate at which a battery charges and discharges, which affects the rate at which lithium ions move within the battery. High currents increase the rate at which lithium ions move within the battery electrodes, which may promote the cation mixing phenomenon. In particular, high currents increase the likelihood of physical stress on the electrode structure, which may accelerate additional degradation mechanisms. Therefore, current information may act as a key factor in estimating the positive electrode active material loss rate related to cation mixing.

In one embodiment, the processor 120 may estimate the determined first reference state data as the first loss rate.

Referring to FIG. 2, the X-axis represents voltage ([V]), the Y-axis represents the first reference state data (dLAM_{P,CM}/dt [Ah/sec]), and the legend represents various temperature conditions by distinguishing them by line type. For example, if the battery data represents a voltage of 3.6 V and a temperature of 30°C, the processor 120 may estimate the y-axis value corresponding to the battery data, 0.42 [Ah/sec], as the first loss rate by referring to the first profile.

In another embodiment, the processor 120 may estimate the first loss rate based on the determined first reference state data and a damping factor. Specifically, the processor 120 may estimate the first loss rate as the value obtained by multiplying the first reference state data by the damping factor. For convenience of explanation, a specific embodiment of estimating the first loss rate using the damping factor is described below.

The processor 120 may determine second reference state data corresponding to the battery data by referring to the second profile, and estimate the second loss rate based on the determined second reference state data.

The second loss rate may refer to the positive electrode active material loss rate related to the particle cracking phenomenon at the positive electrode of the battery.

The processor 120 may be configured to determine second reference state data corresponding to the voltage and current of the battery data by referring to the second profile, and estimate the second loss rate based on the determined second reference state data.

Voltage is closely related to the state of charge of the battery and represents the potential difference across the electrodes during the charge/discharge process of the battery. At certain voltage ranges, electrode particles may experience repeated expansion and contraction as lithium ions are intercalated into or de-intercalated from the electrode, which may lead to stress accumulation within the particles, potentially accelerating particle cracking. Therefore, voltage information may be a crucial criterion for estimating the deterioration progression of the battery and the positive electrode active material loss rate due to particle cracking.

Current represents the charge and discharge rate of the battery, which affects the rate at which lithium ions move through the electrodes. Under high current conditions, electrode particles undergo rapid expansion and contraction, increasing internal particle stress and potentially promoting particle cracking. Therefore, current information may be a crucial factor in estimating the second loss rate.

Temperature controls the rate of chemical reactions within a battery, and higher temperatures accelerate the reaction rate, potentially leading to accelerated particle cracking. High temperatures may exacerbate stress and volume changes within the electrode, potentially weakening the electrode structure, and these conditions may accelerate particle cracking and the loss of positive electrode active material. Therefore, temperature information may be a useful indicator for assessing the state of deterioration due to particle cracking.

In one embodiment, the processor 120 may estimate the second loss rate based on the second reference state data determined from the second profile based on the battery data.

Referring to FIG. 3, the X-axis represents voltage ([V]), the Y-axis represents second reference state data (dLAM_{P,CR}/dt, [Ah/sec]), and the legend represents various current conditions by distinguishing them by line type. For example, if the battery data represents a voltage of 3.6 V and a current of 0.5 C, the processor 120 may estimate the y-axis value corresponding to the battery data, 2.5, as the second loss rate by referring to the second profile.

In another embodiment, the processor 120 may estimate the second loss rate based on the second reference state data determined from the second profile based on the battery data and a damping factor. Specifically, the processor 120 may estimate the second loss rate as a value obtained by multiplying the second reference state data by the damping factor.

The apparatus 100 for diagnosing a battery has the advantage of being able to accurately diagnose the state of the battery by independently analyzing the positive electrode active material loss rate related to cation mixing and particle cracking using the first and second profiles according to conditions such as voltage, current, and temperature.

The processor 120 may be configured to estimate the positive electrode active material loss rate based on the first loss rate and the second loss rate.

Here, the positive electrode active material loss rate may mean a value calculated by comprehensively reflecting various active material loss factors occurring in the battery positive electrode.

For example, the processor 120 may be configured to calculate the positive electrode active material loss rate as a value obtained by adding the first loss rate and the second loss rate. In this case, the positive electrode active material loss rate represents the positive electrode active material loss rate related to the cation mixing phenomenon and the particle cracking phenomenon.

The apparatus 100 for diagnosing a battery has the advantage of being able to comprehensively diagnose the progress of battery deterioration by estimating the positive electrode active material loss rate, which reflects the total proportion of positive electrode active material consumed by a complex interaction of various factors, such as cation mixing and particle cracking.

Below, the method by which the processor 120 calculates the positive electrode active material loss amount is specifically described.

The processor 120 may be configured to calculate a positive electrode active material loss amount of the battery during a reference period based on the positive electrode active material loss rate and a reference period between a previous diagnosis time point and a current diagnosis time point.

The positive electrode active material loss amount during the reference period indicates how much the positive electrode active material of the battery has decreased during the reference period, and may be used as an important indicator for evaluating the deterioration state of the battery and the rate of deterioration.

Specifically, the reference period may refer to the time interval between the previous diagnosis time point and the current diagnosis time point. For example, if the time interval between the previous diagnosis time point and the current diagnosis time point is 0.1 second, the reference period is 0.1 second.

The positive electrode active material loss amount may refer to the amount of active material that has decreased according to the positive electrode active material loss rate during the reference period.

In one embodiment, the processor 120 may calculate the positive electrode active material loss amount as a value obtained by multiplying the reference period and the positive electrode active material loss rate. For example, if the reference period is 0.1 seconds and the positive electrode active material loss rate is 0.5 Ah/second, the positive electrode active material loss amount during the reference period may be calculated as 0.05 Ah.

In another embodiment, the processor 120 may calculate the positive electrode active material loss amount during the reference period by integrating the positive electrode active material loss rate over time.

The apparatus 100 for diagnosing a battery may be used to track the degradation progress of a battery and predict the performance of the battery by calculating the positive electrode active material loss amount over a certain period of time based on the reference period and the positive electrode active material loss rate.

Below, the method for calculating a cumulative positive electrode active material loss amount by using the apparatus 100 for diagnosing a battery is specifically described.

The processor 120 may estimate the cumulative positive electrode active material loss amount up to the current diagnosis time point based on the positive electrode active material loss amount and the cumulative positive electrode active material loss amount up to the previous diagnosis time point.

Specifically, the processor 120 may be configured to estimate the cumulative positive electrode active material loss amount up to the current diagnosis time point by adding the positive electrode active material loss amount to the cumulative positive electrode active material loss amount up to the previous diagnosis time point.

Here, the cumulative positive electrode active material loss amount may represent the total amount of positive electrode active material loss accumulated over time.

The cumulative positive electrode active material loss amount up to the previous diagnosis time point refers to the positive electrode active material loss amount accumulated up to the previous diagnosis time point, and if a reference period is set, it may indicate the cumulative loss amount before the start of the reference period.

For example, the processor 120 may estimate the cumulative positive electrode active material loss amount up to the nth time point by adding the positive electrode active material loss amount between the n-1th time point and the nth time point and the cumulative positive electrode active material loss amount up to the n-1th time point.

As a more specific example, if the cumulative positive electrode active material loss amount up to the previous diagnosis time point is 5 Ah/m³ and the positive electrode active material loss amount during the current reference period is 0.5 Ah/m³, the processor 120 may add the loss amount (0.5 Ah/m³) to the cumulative positive electrode active material loss amount (5 Ah/m³) up to the previous diagnosis time point to determine the cumulative positive electrode active material loss amount up to the current diagnosis time point as 5.5 Ah/m³.

The apparatus 100 for diagnosing a battery may effectively diagnose the long-term deterioration state of battery performance by tracking the cumulative deterioration state of the battery over time by updating the cumulative positive electrode active material loss amount at each reference period.

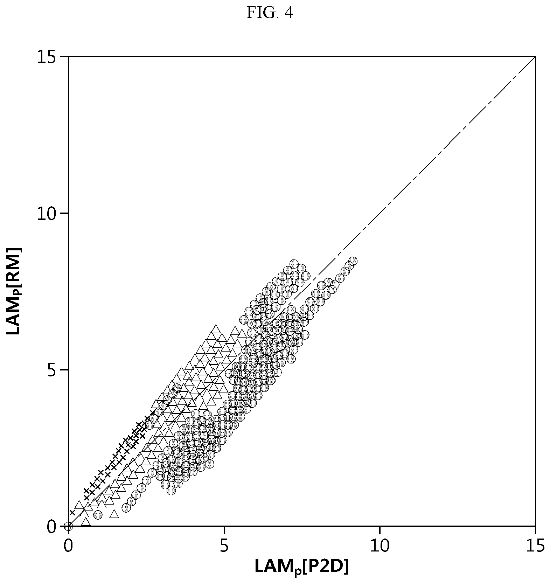

FIG. 4 is a diagram illustrating the correlation between the P2D model and the cumulative positive electrode active material loss amount estimated using the apparatus 100 for diagnosing a battery according to an embodiment of the present disclosure.

In FIG. 4, the horizontal axis represents the cumulative positive electrode active material loss amount (LAM_{P}[P2D]) estimated through the P2D model, and the vertical axis represents the cumulative positive electrode active material loss amount (LAM_{P}[RM]) estimated through the apparatus 100 for diagnosing a battery.

Each data point represents the degree of agreement between the estimates of the P2D model and the RM model, and the closer the points are distributed along the linear trend line, the higher the degree of agreement between the two models.

Referring to FIG. 4, it may be confirmed that the cumulative positive electrode active material loss amount (LAM_{P}[RM]) estimated through the apparatus 100 for diagnosing a battery shows a linear relationship with the cumulative positive electrode active material loss amount (LAM_{P}[P2D]) estimated through the P2D model. That is, the data points of the graph are located close to the linear relationship trend line, indicating that the cumulative positive electrode active material loss amount (LAM_{P}[RM]) of the apparatus 100 for diagnosing a battery shows a high degree of agreement with the cumulative positive electrode active material loss amount (LAM_{P}[P2D]) of the P2D model.

That is, the apparatus 100 for diagnosing a battery may be configured to provide faster computation speed while maintaining a high level of accuracy similar to that of the P2D model based on a lightweight model that approximates the P2D model. Specifically, the apparatus 100 for diagnosing a battery has the advantage of quickly estimating the cumulative positive electrode active material loss amount using a profile (e.g., a lookup table, etc.) composed of pre-calculated data using the P2D model, and maintaining an accuracy close to the precise calculation result of the P2D model.

Below, a specific embodiment of estimating the positive electrode active material loss rate using a damping factor is described.

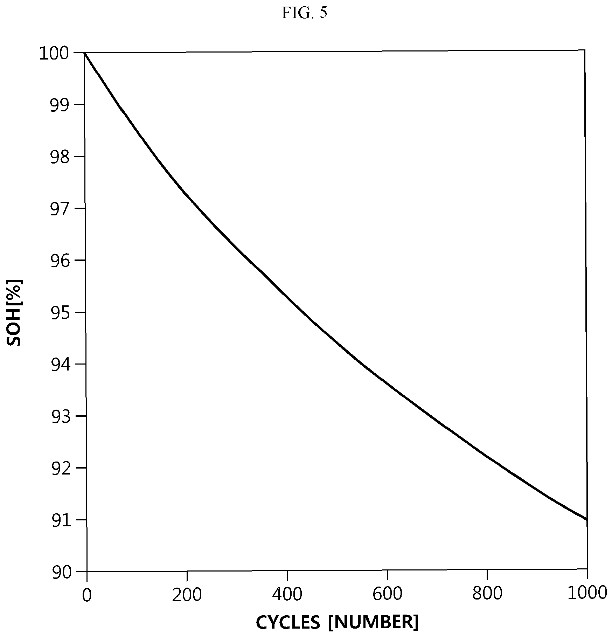

FIG. 5 to FIG. 7 are diagrams schematically illustrating the SOH, the first positive electrode active material loss amount, and the second positive electrode active material loss amount, respectively, according to charge and discharge cycles.

In FIG. 5, the horizontal axis represents the charge/discharge cycle, and the vertical axis represents the SOH ([%]) of the battery.

Referring to FIG. 5, it may be confirmed that the SOH (State of Health) of the battery gradually decreases as the number of charge and discharge cycles increases.

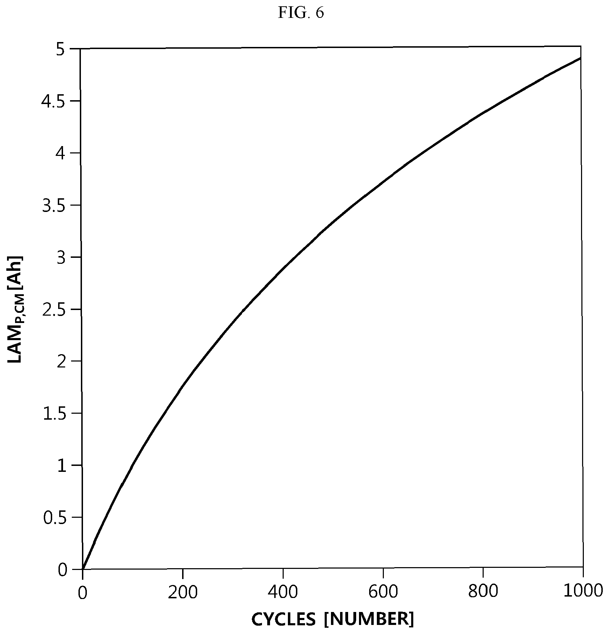

In FIG. 6, the horizontal axis represents the charge/discharge cycle, and the vertical axis represents the first positive electrode active material loss amount (LAM_{P,CM} [Ah]). Here, the first positive electrode active material loss amount may mean the cumulative positive electrode active material loss amount related to cation mixing.

Referring to FIG. 6, it may be confirmed that the first positive electrode active material loss amount gradually increases as the number of charge/discharge cycles increases. That is, the first positive electrode active material loss amount increases rapidly in the initial charge/discharge cycle, but the rate of increase slows down as the cycle progresses.

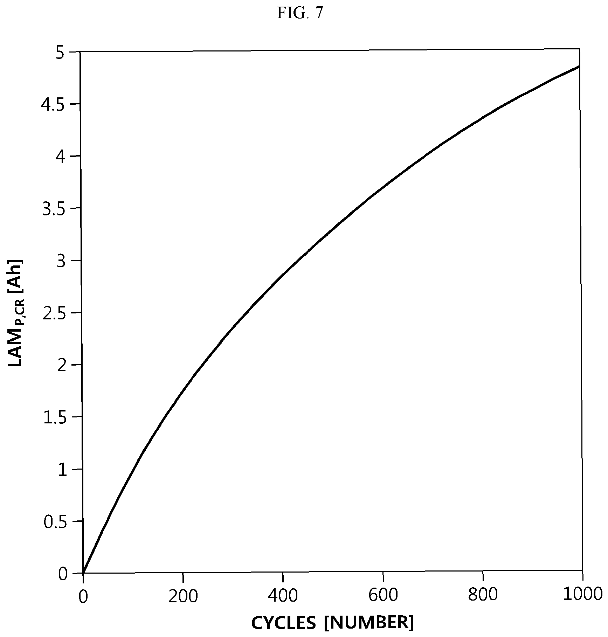

In FIG. 7, the horizontal axis represents the charge/discharge cycle, and the vertical axis represents the second positive electrode active material loss amount (LAM_{P,CR} [Ah]). Here, the second positive electrode active material loss amount may mean the cumulative positive electrode active material loss amount related to particle cracking.

Referring to FIG. 7, it may be confirmed that the second positive electrode active material loss amount gradually increases as the number of charge/discharge cycles increases. That is, the second positive electrode active material loss amount increases rapidly in the initial charge/discharge cycle, but the rate of increase slows down as the cycle progresses.

The apparatus 100 for diagnosing a battery may estimate the positive electrode active material loss rate using a damping factor to more realistically reflect the deterioration state of the battery. That is, the apparatus 100 for diagnosing a battery may model the saturation characteristic in which the positive electrode active material loss rate gradually slows down over time by applying a damping factor.

For example, the damping factor may be set in the form of exp(-γ), where γ is a damping rate coefficient. The damping rate coefficient is a coefficient that reflects the characteristic that the positive electrode active material loss rate gradually slows down as the battery deteriorates. At this time, the larger the damping rate coefficient, the faster the initial loss rate slows down, and the smaller the damping coefficient, the more slowly the loss rate slows down.

In addition, in the early life state (SOH 100%), the initial damping rate coefficient may be set to 0 to calculate the initial loss rate without applying the damping effect. In this case, when the initial damping rate coefficient is set to 0, the initial positive electrode active material loss rate is calculated without the damping effect, and by setting the damping rate coefficient thereafter and applying a damping term in the form of exp(-γ), the effect of alleviating the increase in loss rate over time may be reflected.

The damping rate coefficient may be set based on a negative correlation with the SOH of the battery. For example, relationship data indicating a negative correlation between the SOH and the damping rate coefficient may be pre-stored in the storage unit 130, and the processor 120 may determine the damping rate coefficient from the relationship data by referring to the SOH value of the battery.

That is, as the SOH of the battery decreases, the damping rate coefficient may be set to increase, and as a result, as the deterioration progresses, the damping factor, which has a negative relationship with the damping rate coefficient, gradually decreases.

The processor 120 may determine a damping factor corresponding to the SOH of the battery.

Specifically, the processor 120 may obtain the SOH of the battery. For example, the processor 120 may estimate the SOH of the battery based on the battery data. As another example, the data obtaining unit 110 may receive SOH data from an external source. Also, the processor 120 may receive the SOH data from the data obtaining unit 110. Also, the processor 120 may determine a damping factor corresponding to the SOH of the battery based on pre-stored relational data.

The processor 120 may be configured to estimate the first loss rate based on the first reference state data and the damping factor.

For example, processor 120 may calculate the first loss rate by multiplying the first reference state data determined from the first profile based on battery data by a damping factor. In other words, processor 120 may reflect the slowing effect of the positive electrode active material loss rate due to cation mixing over time by multiplying the first reference state data by a damping factor.

The processor 120 may be configured to estimate the second loss rate based on the second reference state data and the damping factor.

For example, the processor 120 may calculate the second loss rate by multiplying the second reference state data determined from the second profile based on the battery data by a damping factor. In other words, the processor 120 may reflect the slowing effect of the positive electrode active material loss rate due to particle cracking over time by multiplying the second reference state data by a damping factor.

Meanwhile, the damping factor used to estimate the first loss rate and the damping factor used to estimate the second loss rate may be set to the same value or may be set to different values.

For example, the damping factor may be set by considering the change pattern in the positive electrode active material loss rate due to cation mixing and the change pattern in the positive electrode active material loss rate due to particle cracking.

As another example, the damping factor may be set by independently considering the change pattern of the positive electrode active material loss rate due to cation mixing and the change pattern of the positive electrode active material loss rate due to particle cracking. In this case, the positive electrode active material loss rate due to each degradation mechanism may be estimated more precisely.

The apparatus 100 for diagnosing a battery has the advantage of simulating the actual deterioration pattern of the battery more accurately and improving the reliability of battery state diagnosis by estimating the first loss rate and second loss rate using a damping factor.

Below, a specific embodiment of the processor 120 diagnosing the state of a battery is described.

The processor 120 may diagnose the state of the battery based on an estimate related to the loss of active material at the positive electrode.

For example, the processor 120 may compare the loss amount (including the positive electrode active material loss amount and the cumulative positive electrode active material loss amount) with a corresponding threshold value and diagnose the state of the battery based on the comparison result.

Here, the threshold value is a value compared to the loss amount, and is a standard for distinguishing the battery state into a normal state or an abnormal state.

Specifically, the processor 120 may compare the loss amount at the positive electrode with the corresponding threshold value, and diagnose the state of the battery based on the comparison result.

The processor 120 may compare the positive electrode active material loss amount with a preset first threshold value. If the positive electrode active material loss amount is greater than or equal to the first threshold value, the processor 120 may diagnose the battery state as an abnormal state. Conversely, if the positive electrode active material loss amount is less than the first threshold value, the processor 120 may diagnose the battery state as a normal state.

The processor 120 may compare the cumulative positive electrode active material loss amount with a preset second threshold value. If the cumulative positive electrode active material loss amount is greater than or equal to the second threshold value, the processor 120 may diagnose the battery state as an abnormal state. Conversely, if the cumulative positive electrode active material loss amount is less than the second threshold value, the processor 120 may diagnose the battery state as a normal state.

The apparatus 100 for diagnosing a battery has the advantage of being able to precisely diagnose the state of the battery and improve the safety of the battery by comparing the loss amount with a threshold value.

The cumulative positive electrode active material loss amount may be used to calculate the SOH of the battery.

In one embodiment, the processor 120 may consider the cumulative positive electrode active material loss amount along with the cumulative negative electrode active material loss amount and the cumulative available lithium loss amount to calculate the SOH of the battery.

The negative electrode active material loss refers to the reduction of active material at the negative electrode of a lithium-ion battery, and is a major cause of battery deterioration. The cumulative negative electrode active material loss amount may refer to the difference between the initial negative electrode active material capacity and the current negative electrode active material capacity.

The available lithium loss refers to the loss of lithium ions that may be used for charging and discharging within the battery. The cumulative available lithium loss amount may refer to the difference between the initial available lithium-ion amount and the current available lithium-ion amount.

The processor 120 may calculate the SOH by adjusting the pre-stored criterion positive electrode profile and criterion negative electrode profile based on the cumulative positive electrode active material loss amount, the cumulative negative electrode active material loss amount, and the cumulative available lithium loss amount. The cumulative negative electrode active material loss amount and the cumulative available lithium loss amount may be obtained by various known methods.

The criterion positive electrode profile is a profile that represents the corresponding relationship between the capacity and voltage of a criterion positive electrode cell preset to correspond to the positive electrode of a battery. For example, the criterion positive electrode cell may be a positive electrode coin half cell or a positive electrode of a three-electrode cell. In addition, the criterion negative electrode profile is a profile that represents the corresponding relationship between the capacity and voltage of a criterion negative electrode cell preset to correspond to the negative electrode of a battery. For example, the criterion negative electrode cell may be a negative electrode coin half cell or a negative electrode of a three-electrode cell.

The processor 120 may shrink the criterion positive electrode profile considering the cumulative positive electrode active material loss amount, and may shrink the criterion negative electrode profile considering the cumulative negative electrode active material loss amount. The shrinkage amount of the criterion positive electrode profile and the cumulative positive electrode active material loss amount may have a predetermined positive correspondence. The shrinkage amount of the criterion negative electrode profile and the cumulative negative electrode active material loss amount may have a predetermined positive correspondence.

Then, the processor 120 may shift the shrunken criterion positive electrode profile and the shrunken criterion negative electrode profile based on the cumulative available lithium loss amount to generate a corrected positive electrode profile and a corrected negative electrode profile. For example, the processor 120 may shift the shrunken criterion positive electrode profile and the shrunken criterion negative electrode profile in a negative direction (i.e., toward the low capacity side) on the capacity axis based on the cumulative available lithium loss amount to generate a corrected positive electrode profile and a corrected negative electrode profile. The amount of parallel shift and the cumulative available lithium loss amount may have a predetermined positive correspondence.

Afterwards, the processor 120 may generate a full cell profile based on the difference between the corrected positive electrode profile and the corrected negative electrode profile. The full cell profile represents the corresponding relationship between the voltage and capacity of the battery.

The processor 120 may estimate the SOH of the battery by comparing the generated full cell profile with the pre-stored criterion full cell profile.

Here, the criterion full cell profile represents the corresponding relationship between the voltage and capacity obtained for the battery in the beginning of life (BOL) state. The criterion full cell profile may be pre-stored in a memory or the like based on the difference between the potential of the criterion positive electrode profile and the potential of the criterion negative electrode profile in a predetermined capacity range. For example, the processor 120 may calculate the SOH of the battery by calculating the ratio between the size of the capacity section of the generated full cell profile and the size of the capacity section of the criterion full cell profile.

The apparatus 100 for diagnosing a battery according to an embodiment of the present disclosure may estimate the SOH of a battery based on the cumulative positive electrode active material loss amount, thereby effectively diagnosing the performance degradation of the battery.

The apparatus 100 for diagnosing a battery may be configured to set usage conditions based on the results of the state diagnosis for the battery.

In one embodiment, the processor 120 may be configured to set a usage condition of the battery based on at least one of the positive electrode active material loss rate, the positive electrode active material loss amount, the cumulative positive electrode active material loss amount, the state of the battery, and the SOH.

For example, if the state of the battery is diagnosed as a normal state, the processor 120 may maintain the existing usage condition. Conversely, if the state of the battery is diagnosed as an abnormal state, the processor 120 may change the existing usage condition. For example, if the state of the battery is diagnosed as an abnormal state, the processor 120 may be configured to reduce the maximum charge/discharge rate. As another example, if the state of the battery is diagnosed as an abnormal state, the processor 120 may be configured to reduce the charge termination voltage. Here, the charge termination voltage may mean the maximum voltage allowed when charging the battery. As another example, if the state of the battery is diagnosed as an abnormal state, the processor 120 may increase the discharge termination voltage. Here, the discharge termination voltage may mean the minimum voltage allowed when discharging the battery.

In another embodiment, the processor 120 may set the usage condition of the battery according to a preset protocol that defines a corresponding relationship between the usage condition and at least one of the positive electrode active material loss rate, the positive electrode active material loss amount, the cumulative positive electrode active material loss amount, the state and SOH of the battery.

Meanwhile, it goes without saying that various methods that can be easily applied by a person with ordinary knowledge in the technical field to which the present disclosure belongs may be used for specific embodiments of setting the usage conditions of the battery.

The apparatus 100 for diagnosing a battery according to an embodiment of the present disclosure may mitigate performance degradation of the battery and improve its lifespan and stability by appropriately controlling the usage condition of the battery by considering the state diagnosis results of the battery.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the data obtaining unit 110 and the processor 120 of the apparatus for diagnosing a battery may be implemented as components of the BMS.

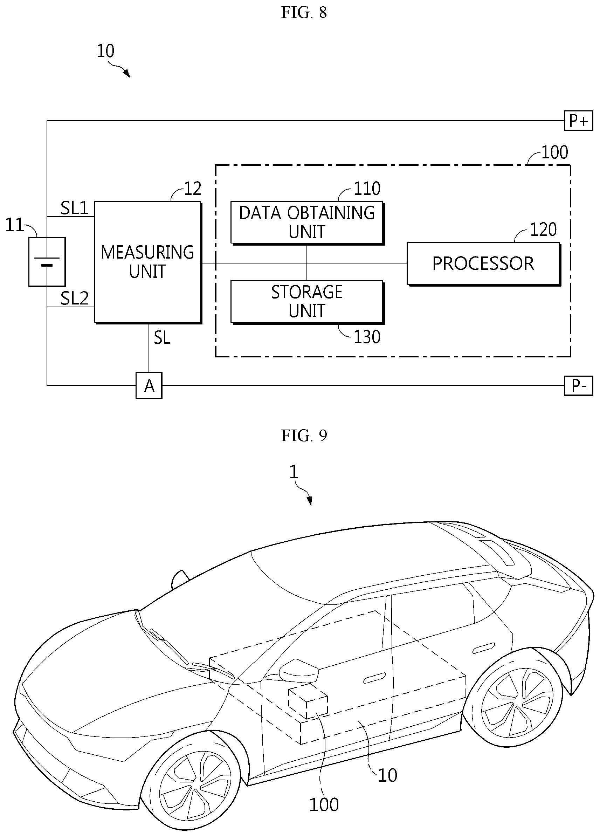

FIG. 8 is a drawing schematically illustrating a battery pack 10 according to another embodiment of the present disclosure.

The apparatus 100 for diagnosing a battery according to the present disclosure may be provided in the battery pack 10. That is, the battery pack 10 according to the present disclosure may include the above-described apparatus 100 for diagnosing a battery and at least one battery cell. Additionally, the battery pack 10 may further include electrical components (relays, fuses, etc.) and a case.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1, and to the negative electrode terminal of the battery 11 through the second sensing line SL2. The measuring unit 12 may measure the voltage of the battery 11 based on the voltage measured at each of the first sensing line SL1 and the second sensing line SL2.

In addition, the measuring unit 12 may be connected to the current measurement unit A via the third sensing line SL3. For example, the current measurement unit A may be a current meter or a shunt resistor capable of measuring the charging current and discharging current of the battery 11. The measuring unit 12 may measure the charging current of the battery 11 via the third sensing line SL3 to calculate the charge amount. In addition, the measuring unit 12 may measure the discharging current of the battery 11 via the third sensing line SL3 to calculate the discharge amount.

The data obtaining unit 110 may be connected to the measuring unit 12 via a wire and/or wireless connection to enable communication. The data obtaining unit 110 may receive voltage, current, and/or temperature information of the battery 11 from the measuring unit 12.

FIG. 9 is a drawing schematically illustrating a vehicle 1 according to still another embodiment of the present disclosure.

Referring to FIG. 9, the battery pack 10 described above with reference to FIG. 8 may be included in a vehicle 1, such as an electric vehicle (EV) or a hybrid vehicle (HV). In addition, the battery pack 10 may drive the vehicle 1 by supplying power to a motor through an inverter provided in the vehicle 1. Here, the battery pack 10 may include the apparatus 100 for diagnosing a battery. In this case, the apparatus 100 for diagnosing a battery may be an on-board device included in the vehicle 1.

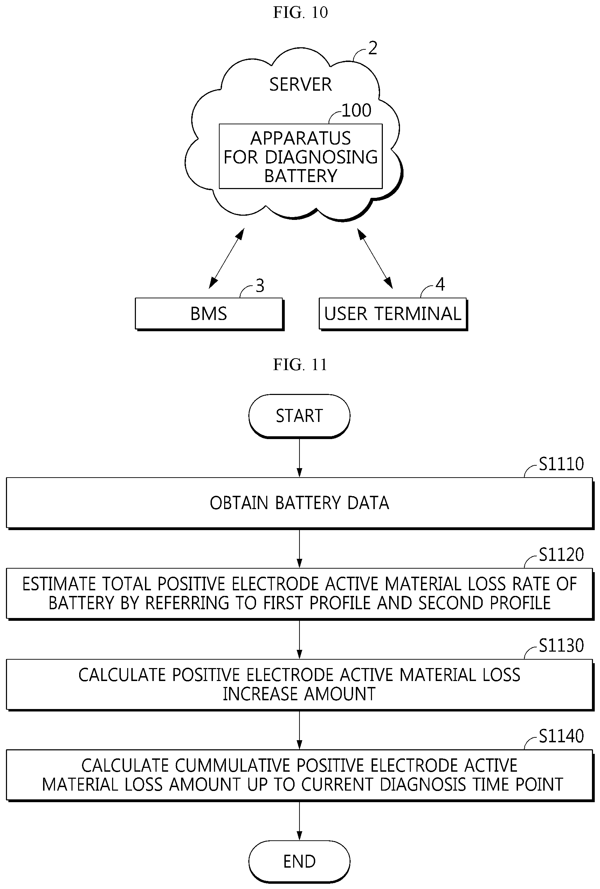

FIG. 10 is a drawing schematically illustrating a server 2 according to still another embodiment of the present disclosure.

Referring to FIG. 10, the apparatus 100 for diagnosing a battery according to the present disclosure may be equipped on a server 2. The server 2 provides high-performance computing resources and data storage functions to estimate a positive electrode active material loss rate.

The apparatus 100 for diagnosing a battery installed on the server 2 may individually acquire battery data from a plurality of BMS 3, analyze it in real time, and continuously monitor the positive electrode active material loss rate of each battery. Specifically, the apparatus 100 for diagnosing a battery running on the server 2 may estimate the first loss rate and the second loss rate of the battery by referring to the first profile and the second profile based on the battery data. Furthermore, the apparatus 100 for diagnosing a battery running on the server 2 may estimate the positive electrode active material loss rate of the battery, the positive electrode active material loss amount during a reference period, and the cumulative positive electrode active material loss amount. In addition, the apparatus 100 for diagnosing a battery running on the server 2 may diagnose the state of the battery based on the estimated value related to the positive electrode active material loss.

The apparatus 100 for diagnosing a battery equipped in the server 2 may perform integrated management on the battery system including a plurality of batteries by being linked with a plurality of BMS 3, a user terminal 4, and/or a vehicle control system 5. The server 2 may be connected wired and/or wirelessly to enable communication with the plurality of BMS 3 and/or the user terminal 4.

The server 2 may be linked with the BMS 3 to transmit an estimated value related to the loss of the positive electrode active material of the battery and/or the diagnosis results to the corresponding BMS 3 in real time. Alternatively, if the state of the battery is diagnosed as an abnormal state, the server 2 may transmit a warning or control signal to the corresponding BMS 3.

The server 2 may be linked with the user terminal 4 to enable the user to remotely monitor the state of the battery. The user may check the state of the battery in real time using a dedicated application.

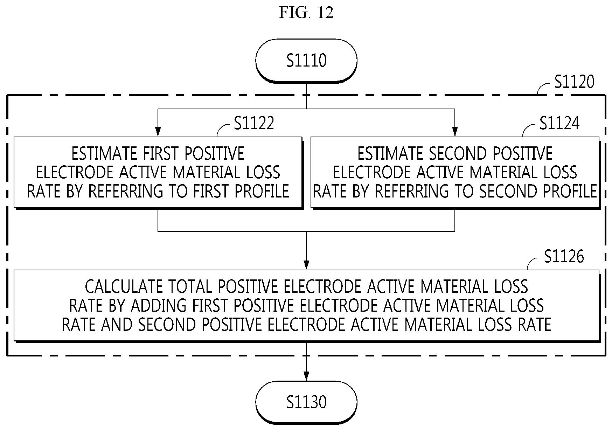

FIG. 11 is a diagram schematically showing a method for diagnosing a battery according to still another embodiment of the present disclosure. FIG. 12 is a drawing schematically illustrating the sub-steps of step S1120 of FIG. 11.

Each step of the method for diagnosing a battery may be performed by the apparatus 100 for diagnosing a battery. Hereinafter, for convenience of explanation, the content overlapping with the previously described content will be briefly described or omitted.

Referring to FIG. 11, the method for diagnosing a battery includes steps S1110 and S1120. The method for diagnosing a battery may further include steps S1130 and S1140.

Step S1110 is a step of obtaining battery data including at least one of voltage, current, and temperature of a battery, and may be performed by the data obtaining unit 110.

Step S1120 is a step of estimating a positive electrode active material loss rate of the battery by referring to a first profile provided for estimating a positive electrode active material loss related to cation mixing and a second profile provided for estimating a positive electrode active material loss related to particle cracking based on the battery data, and may be performed by the processor 120.

Referring to FIG. 12, step S1120 may include steps S1122, S1124, and S1126.

Step S1122 is a step of estimating the first loss rate by referring to the first profile, and may be performed by the processor 120.

In one embodiment, the processor 120 may estimate the determined first reference state data as the first loss rate.

In another embodiment, the processor 120 may estimate a first loss rate based on the determined first reference state data and a damping factor.

Specifically, the processor 120 may estimate the value obtained by multiplying the first reference state data by a damping factor as the first loss rate.

Step S1124 is a step of estimating a second loss rate by referring to the second profile, and may be performed by the processor 120.

In one embodiment, the processor 120 may estimate the second loss rate based on the second reference state data determined from the second profile based on the battery data.

In another embodiment, the processor 120 may estimate the second loss rate based on the second reference state data determined from the second profile based on the battery data and a damping factor.

Specifically, the processor 120 may estimate the second loss rate as the value obtained by multiplying the second reference state data and the damping factor.

Step S1126 is a step of calculating a positive electrode active material loss rate by adding the first loss rate and the second loss rate, and may be performed by the processor 120.

Step S1130 is a step of calculating a positive electrode active material loss amount of the battery during a reference period based on the positive electrode active material loss rate and the reference period between a previous diagnosis time point and a current diagnosis time point, and may be performed by the processor 120.

Step S1140 is a step of calculating a cumulative positive electrode active material loss amount up to the current diagnosis time point by adding the positive electrode active material loss amount to the cumulative positive electrode active material loss amount up to the previous diagnosis time point, and may be performed by the processor 120.

Another embodiment of the present disclosure may provide a computer-readable storage medium on which a program for performing the various embodiments described above on a computer is recorded.

The program may be implemented as hardware components, software components, and/or a combination of hardware components and software components. The program may be executed by any system capable of executing computer-readable instructions.

Software may include computer programs, codes, instructions, or a combination thereof, which may configure a processing device to perform a desired operation or may independently or collectively command a processing device.

The software may be implemented as a computer program including instructions stored on a computer-readable storage medium. Examples of the computer-readable storage medium include magnetic storage media (e.g., read-only memory (ROM), random-access memory (RAM), floppy disks, hard disks, etc.) and optical reading media (e.g., CD-ROM, DVD: Digital Versatile Disc). The computer-readable storage medium may be distributed across network-connected computer systems so that the computer-readable codes may be stored and executed in a distributed manner. The storage medium may be readable by a computer, stored in a memory, and executed by a processor.

A computer-readable storage medium may be provided in the form of a non-transitory storage medium. Here, the term 'non-transitory storage medium' simply means that it is a tangible device and does not contain signals (e.g., electromagnetic waves), and this term does not distinguish between cases where data is stored semi-permanently on the storage medium and cases where data is stored temporarily. For example, the 'non-transitory storage medium' may include a buffer in which data is temporarily stored.

Additionally, the program may be provided as part of a computer program product. The computer program product may be traded between sellers and buyers as a commodity.

A computer program product may include a software program, and a computer-readable storage medium storing the software program. For example, the computer program product may include a product in the form of a software program (e.g., a downloadable application) distributed electronically by a manufacturer of an electronic device or through an electronic market. For electronic distribution, at least a portion of the software program may be stored on a storage medium or temporarily generated. In this case, the storage medium may be a storage medium of a server of a manufacturer of an electronic device, a server of an electronic market, or a relay server that temporarily stores the software program.

The embodiments of the present disclosure described above may not be implemented only through an apparatus and a method, but may be implemented through a program that realizes a function corresponding to the configuration of the embodiments of the present disclosure or a storage medium on which the program is recorded. The program or storage medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference symbols)

1: vehicle
2: server
3: BMS
4: user terminal
10: battery pack
11: battery
12: measuring unit
100: apparatus for diagnosing a battery
110: data obtaining unit
120: processor
130: storage unit

## Claims

1. An apparatus for diagnosing a battery, comprising:
a data obtaining unit configured to obtain battery data including at least one of voltage, current, and temperature of the battery; and
a processor configured to estimate a positive electrode active material loss rate of the battery based on the battery data by referring to a first profile provided for estimating a positive electrode active material loss related to cation mixing and a second profile provided for estimating a positive electrode active material loss related to particle cracking.

2. The apparatus for diagnosing a battery according to claim 1,
wherein the first profile is configured to represent a corresponding relationship between a plurality of reference battery data and a plurality of first reference state data.

3. The apparatus for diagnosing a battery according to claim 1,
wherein the second profile is configured to represent a corresponding relationship between a plurality of reference battery data and a plurality of second reference state data.

4. The apparatus for diagnosing a battery according to claim 1,
wherein the processor is configured to determine first reference state data corresponding to the voltage and the temperature of the battery data by referring to the first profile and estimate a first loss rate based on the determined first reference state data.

5. The apparatus for diagnosing a battery according to claim 4,
wherein the processor is configured to estimate the first loss rate based on the first reference state data and a damping factor.

6. The apparatus for diagnosing a battery according to claim 1,
wherein the processor is configured to determine second reference state data corresponding to the voltage and the current of the battery data by referring to the second profile and estimate a second loss rate based on the determined second reference state data.

7. The apparatus for diagnosing a battery according to claim 6,
wherein the processor is configured to estimate the second loss rate based on the second reference state data and a damping factor.

8. The apparatus for diagnosing a battery according to claim 1,
wherein the processor is configured to estimate first reference state data corresponding to the voltage and the temperature of the battery data as a first loss rate by referring to the first profile, estimate second reference state data corresponding to the voltage and the current of the battery data as a second loss rate by referring to the second profile, and estimate the positive electrode active material loss rate based on the first loss rate and the second loss rate.

9. The apparatus for diagnosing a battery according to claim 8,
wherein the processor is configured to calculate a value obtained by adding the first loss rate and the second loss rate as the positive electrode active material loss rate.

10. The apparatus for diagnosing a battery according to claim 1,
wherein the processor is configured to calculate a positive electrode active material loss amount of the battery during a reference period based on the positive electrode active material loss rate and the reference period between a previous diagnosis time point and a current diagnosis time point.

11. The apparatus for diagnosing a battery according to claim 10,
wherein the processor is configured to calculate a cumulative positive electrode active material loss amount up to the current diagnosis time point by adding the positive electrode active material loss amount to a cumulative positive electrode active material loss amount up to the previous diagnosis time point.

12. A battery pack, comprising the apparatus for diagnosing a battery according to any one of claims 1 to 11.

13. A vehicle, comprising the apparatus for diagnosing a battery according to any one of claims 1 to 11.

14. A server, comprising the apparatus for diagnosing a battery according to any one of claims 1 to 11.

15. A method for diagnosing a battery, comprising:
obtaining battery data including at least one of voltage, current, and temperature of the battery; and
estimating a positive electrode active material loss rate of the battery based on the battery data by referring to a first profile provided for estimating a positive electrode active material loss related to cation mixing and a second profile provided for estimating a positive electrode active material loss related to volume change due to particle cracking.

16. A computer-readable storage medium storing a program for executing the method for diagnosing a battery according to claim 15 on a computer.
